# EUROPÄISCHE PATENTSCHRIFT

(11) **EP 1 337 700 B1**
(45) Veröffentlichungstag und Bekanntmachung des Hinweises auf die Patenterteilung: **24.08.2005**
(21) Anmeldenummer: 01978454.5
(22) Anmeldetag: 25.10.2001
(51) Int. Cl.: C30B 25/10, C30B 25/14

(54) **CVD-REAKTOR MIT VON EINEM GASSTROM DREHGELAGERTEN UND -ANGETRIEBENEN SUBSTRATHALTER**
CVD REACTOR COMPRISING A SUBSTRATE HOLDER ROTATABLY MOUNTED AND DRIVEN BY A GAS FLOW
REACTEUR DE DEPOT CHIMIQUE EN PHASE VAPEUR COMPORTANT UN SUPPORT DE SUBSTRAT LOGE DE MANIERE ROTATIVE ET ENTRAINE PAR UN FLUX GAZEUX

(30) Priorität: 08.11.2000 DE 10055182
(43) Veröffentlichungstag der Anmeldung: 27.08.2003
(73) Patentinhaber: Aixtron AG, 52072 Aachen (DE)
(72) Erfinder: KÄPPELER, Johannes, 52146 Würselen (DE); WISCHMEYER, Frank, 52072 Aachen (DE); BERGE, Rune, S-22370 Lund (SE)
(74) Vertreter: Grundmann, Dirk
(86) Internationale Anmeldenummer: PCT/EP2001/012311
(87) Internationale Veröffentlichungsnummer: WO 2002/038839

(56) Entgegenhaltungen:
- EP-A- 0 748 881
- WO-A-00/14310
- WO-A-88/10324
- WO-A-89/00212
- WO-A-97/31134
- WO-A-98/51844

## Beschreibung

Die Erfindung betrifft eine Vorrichtung zum Abscheiden insbesondere kristalliner Schichten auf insbesondere kristallinen Substraten mit einer in einem Reaktorgehäuse angeordneten Prozesskammer, deren Boden mindestens einen in einer Lagerausnehmung auf einem Gaspolster getragenen, durch den das Gaspolster aufrechterhaltenen, durch eine dem Boden zugeordneten Zuleitung strömenden Gasstrom drehangetriebenen Substrathalter trägt.

Derartige Vorrichtungen werden verwendet, um beispielsweise Halbleiterschichten aus der Gasphase über dem Substrat zugeleiteten Reaktionsgasen abzuscheiden. Dabei wird zumindest der Boden der Prozesskammer aufgeheizt, so dass die Reaktionsgase in der zufolge der Prozesskammerwandaufheizung erwärmten Gasphase sich zersetzen und die Zersetzungsprodukte auf dem Substrat kondensieren. Aus der WO 96/23913 ist beispielsweise eine Vorrichtung zum epitaktischen Wachstum von Siliciumkarbid bekannt, bei welcher die Prozesskammer von einem Grafitrohr gebildet ist, welches mit Hochfrequenz beheizt wird. Aus dieser Schrift ist es bekannt, das Substrat nicht unmittelbar auf den Prozesskammerboden zu legen, sondern auf eine auf dem Boden liegende Platte.

Aus der US 6,039,812 A ist ebenfalls ein CVD-Reaktor zum Abscheiden von Siliciumkarbid vorbekannt. Dort ist der Eingang der Prozesskammer mittels eines Rohres mit einem Gaseinlass-System verbunden.

Einen CVD-Reaktor mit auf einem Gaspolster drehgelagerten und von dem Gasstrom drehangetriebenen Substrathalter zeigt die US 4,961,399. Die Prozesskammer ist dort zylindersymmetrisch um ein Gaseinlassorgan angeordnet. Dort sind insgesamt fünf drehbare Substrathalter vorgesehen.

Der Erfindung liegt die Aufgabe zugrunde, das Konzept des auf einem Gasstrom drehgelagerten Substrathalters technologisch insbesondere in einer lineardurchströmten Prozesskammer weiterzubilden.

Gelöst wird die Aufgabe durch die in den Ansprüchen angegebene Erfindung.

Der Anspruch 1 sieht zunächst und im Wesentlichen vor, dass die Lagerausausnehmung einem über der Austrittsöffnung der Zuleitung angeordneten Tablett zugeordnet ist. Dieses Tablett kann bei einem tunnelförmigen, lineardurchströmten Reaktor einseitig, insbesondere durch die stromabwärtige Öffnung der Prozesskammer entnommen werden, um das Substrat auf dem Substrathalter zu wechseln. In einer bevorzugten Weiterbildung der Erfindung ist vorgesehen, dass das Tablett mit einem Ringwulst ausgestattet ist. Dieser Ringwulst weist nach unten. Innerhalb des vom Ringwulst umgebenen Bereiches sind bevorzugt Durchtrittsöffnungen vorgesehen, durch welche das Gas, welches den Substrathalter trägt und drehantreibt, strömen kann. Bevorzugt liegt dieser Ringwulst in einer einer Stufe des Prozesskammerbodens zugeordneten Ringnut. Hierdurch ist eine Selbstzentrierung und Halterung des Tabletts in der Stufe des Prozesskammerbodens gewährleistet. Der bevorzugt scharfkantig zulaufende Ringwulst liegt dichtend auf dem Grund der Ringnut auf, so dass sich zwischen der Oberfläche der Stufe und der Unterseite des Tabletts ein abgeschlossenes Volumen ausbildet, in welches die Öffnung der Zuleitung mündet. Dieses Volumen dient zur Gasverteilung des durch die Öffnung strömenden Gasstroms auf eine Vielzahl von Durchtrittsöffnungen, die in bekannter Weise in Spiralnuten des Bodens der Lagerausnehmung münden, um so den Substrathalter zu lagern und drehanzutreiben. Die Zuleitung verläuft bevorzugt innerhalb eines den Boden ausbildenden Grafitkörpers. Die Zuleitung beginnt bevorzugt unterhalb der stromaufwärtigen Prozesskammeröffnung, so dass zwei Öffnungen übereinander angeordnet sind, an welche Gaseinlassrohre anschließbar sind, um die Reaktionsgase in die Prozesskammer bzw. ein Inertgas der Zuleitung zuzuführen. Diese beiden Rohrleitungen verlaufen parallel zueinander und entspringen einem gemeinsamen Gaseinlassorgan.

Eine eigenständige erfinderische Weiterbildung der gattungsgemäßen Vorrichtung sieht vor, dass der Boden von einem Höhlungsabschnitt eines, ein im Wesentlichen rechteckiges Innenquerschnittsprofil aufweisenden, insbesondere mehrteiligen Grafitrohr gebildet ist, wobei dem ersten Rohrende ein Gaseinlassorgan für ein oder mehrere Reaktionsgase zugeordnet ist und das zweite Rohrende eine Beladeöffnung für die Prozesskammer ausbildet, und wobei vom Gaseinlassorgan ein Reaktionsgaseinlassrohr bis zur stirnseitigen Öffnung der Prozesskammer und ein davon getrenntes Rohr bis zur darunter liegenden Öffnung der Zuleitung ausgehen.

Die Erfindung betrifft ferner ein Verfahren zum Abscheiden insbesondere von Siliciumkarbid mittels in die Gasphase gebrachter metallorganischer Verbindungen. Erfindungsgemäß ist dabei vorgesehen, dass in der Prozesskammer ein Tablett angeordent ist. Dieses ist zum Be- und Entladen der Prozesskammer mit den Substraten entnehmbar.

Ein Ausführungsbeispiel der Erfindung wird nachfolgend anhand beigefügter Zeichnungen erläutert. Es zeigen:

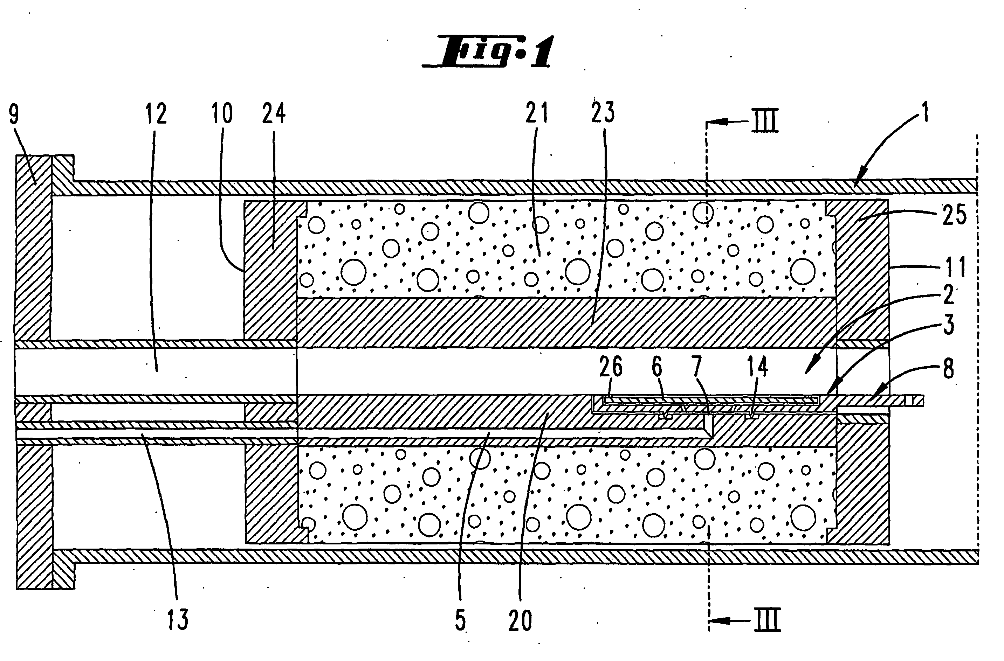

- Fig. 1: eine Schnittdarstellung durch einen CVD-Reaktor,

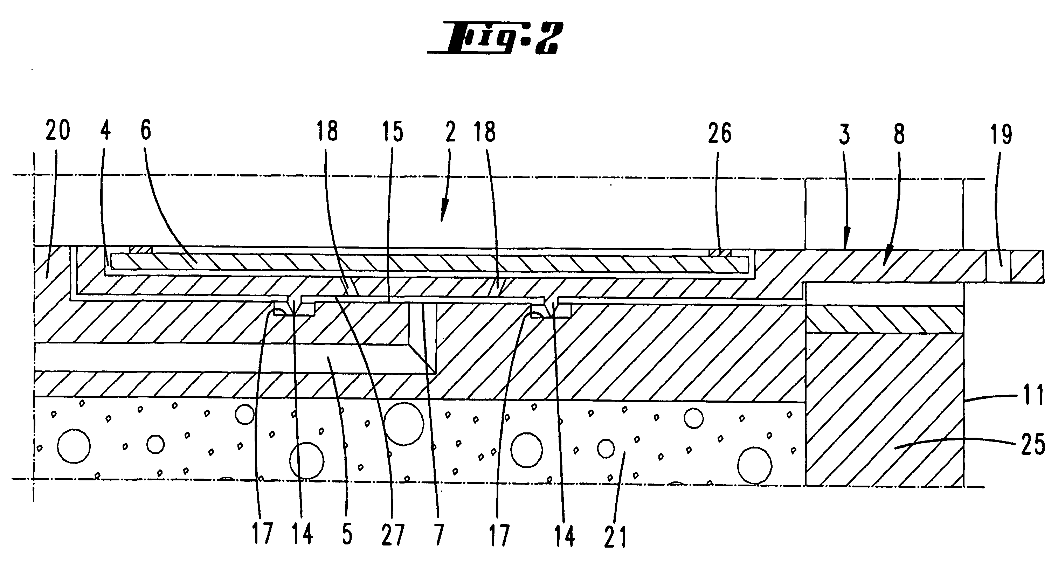

- Fig. 2: eine vergrößerte Darstellung des Bodens der Prozesskammer im Bereich deren stromabwärtigen Ende und

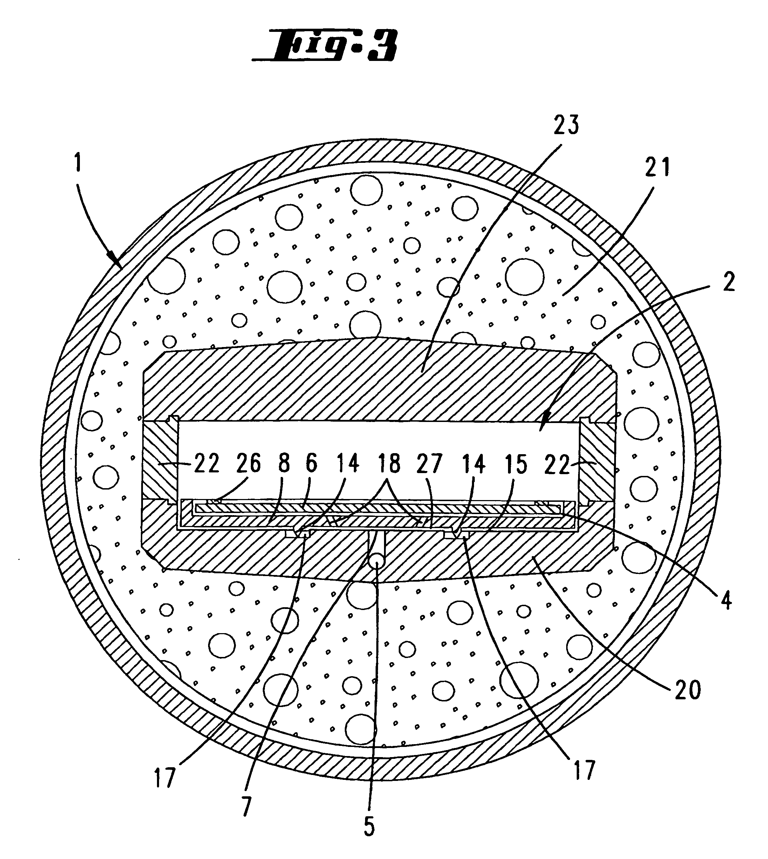

- Fig. 3: einen Schnitt gemäß der Schnittlinien III-III in den Figuren 1 und 2.

Das Ausführungsbeispiel betrifft einen CVD-Reaktor zum Abscheiden von Siliciumkarbidschichten, wie er grundsätzlich aus der US 6,039,812 bzw. der WO 96/23913 vorbekannt ist. Der Reaktor besitzt ein Reaktorgehäuse 1, welches als Quarzrohr ausgebildet ist. Um dieses Quarzrohr befindet sich eine nicht dargestellte HF-Spule, um die Prozesskammer aufzuheizen. Die Prozesskammer 2 liegt innerhalb des Reaktorgehäuses und besteht aus einem mehrteiligen Grafitrohr. Das Grafitrohr besitzt einen Boden 3, welches von einem Grafitkörper 20 gebildet ist. Die oberhalb des Bodens 3 angeordnete Prozesskammer 2 wird seitlich durch zwei Wände 22 begrenzt, auf denen eine Decke 23 liegt. Um das Grafitrohr 20, 22, 23 befindet sich eine Grafitschaum-Manschette 21. An den beiden Stirnseiten der Grafitkörper 20, 22, 23 befinden sich Scheiben 24, 25, die aus massivem Grafit bestehen.

Die am stromaufwärtigen Ende 10 angeordnete Stirnöffnung der Prozesskammer 2 ist mittels eines Reaktionsgaseinlassrohres 12 mit einem Gaseinlassorgan 9 verbunden. Durch dieses Reaktionsgaseinlassrohr 12 strömen die Reaktionsgase in die Prozesskammer 2.

Unterhalb des Reaktionsgaseinlassrohres 12 befindet sich ein Rohr 13, durch welches ein Inertgas geleitet wird. Dieses Rohr 13 mündet in eine Öffnung einer im Prozesskammerboden 3 verlaufende Zuleitung 5. Die Zuleitung 5 mündet in den Boden einer stromabwärtigen Stufe 15 des Prozesskammerbodens 3.

Auf der Stufe 15 ist ein Tablett 8 angeordnet. Die Stufe 15 bildet eine die Austrittsöffnung 7 der Zuleitung 5 umgebende Ringnut 17. Auf dem Grund der Ringnut 17 stützt sich ein Ringwulst 14 ab, der zur Unterseite des Tabletts 8 gehört und scharfkantig zuläuft. Zusammen mit der Ringnut 17 bildet dieser Wulst 14 ein abgeschlossenes Volumen, welches eine Gasverteilkammer 27 ist. Aus dieser Gasverteilkammer 27 gehen Durchtrittsöffnungen 18 in eine Lagerausnehmung 4 des Tabletts 8. Die Durchtrittsöffnungen 18 münden dort in nicht dargestellte Spiralnuten, die in den Boden der Lagerausnehmung 4 eingearbeitet sind.

In der Lagerausnehmung 4 liegt ein kreisscheibenförmiger Substrathalter 6 ein. Der durch die Durchtrittsöffnungen 8 austretende Gasstrom hebt in bekannter Weise den Substrathalter 6 an. Zufolge der spiralartigen Orientierung der Nuten wird der Substrathalter 6 von dem Gasstrom nicht nur gelagert, sondern auch drehangetrieben. Auf dem Substrathalter 6 liegt das nicht dargestellte, zu beschichtende Substrat auf. Es kann von einem Siliciumkarbid-Ring 26 umgeben sein.

Das Tablett 8 besitzt einen Fortsatz, welcher aus dem stromabwärtigen Ende 11 der Prozesskammer 2 herausragt. Dieser Fortsatz besitzt eine Werkzeugangriffsöffnung 19, an welcher ein Werkzeug ansetzen kann, um dass Tablett 8 aus der Prozesskammer 2 herauszunehmen. Hierzu muss das Tablett 8 zunächst angehoben werden, damit der Ringwulst 14 aus der Nut 17 gelangt. Dann kann das Tablett 8 mit samt dem darauf liegenden Substrathalter 6 aus der Prozesskammer 2 herausgenommen werden.

Die Grafitkörper der Prozesskammer können mit Siliciumkarbid oder Tantalkarbid beschichtet sein.

Die Gasströmung in den beiden Rohrleitungen 12, 13 erfolgt parallel. Dementsprechend ist auch die Reaktionsgasströmung in der Prozesskammer 2 parallel gerichtet zu Strömung des Inertgases in der Zuleitung 5.

## Patentansprüche

1. Vorrichtung zum Abscheiden insbesondere kristalliner Schichten auf insbesondere kristallinen Substraten, mit einer in einem Reaktorgehäuse (1) angeordneten Prozesskammer (2), deren Boden (3) mindestens einen in einer Lagerausnehmung (4) auf einem Gaspolster getragenen, durch den das Gaspolster aufrechterhalten, durch eine dem Boden zugeordneten Zuleitung (5) strömenden Gasstrom drehangetrieben Substrathalter (6) trägt, **dadurch gekennzeichnet, dass** die Lagerausnehmung (4) einem über der Austrittsöffnung (7) der Zuleitung (5) angeordneten Tablett (8) zugeordnet ist.

2. Vorrichtung nach Anspruch 1, **dadurch gekennzeichnet, dass** das Tablett mit einem Dichtwulst (14) auf einer Stufe (15) eines den Boden (3) bildenden Grafitkörpers (16) aufliegt.

3. Vorrichtung nach Anspruch 2, **dadurch dadurch gekennzeichnet, dass** der ringförmige Dichtwulst (14) in einer der Stufe (15) zugeordneten Ringnut (17) liegt.

4. Vorrichtung nach Anspruch 3, **gekennzeichnet durch** versetzt zu der von der Ringnut (17) umgebenden Austrittsöffnung (7), von dem Dichtwulst (14) umgebende Durchtrittsöffnungen (18) zum Durchtritt des Lagergasstromes in die Lagerausnehmung (4).

5. Vorrichtung nach einem der vorhergehenden Ansprüche, **dadurch gekennzeichnet, dass** der Lagergasstrom in der Zuleitung (5) zur Strömung der Reaktionsgase in der Prozesskammer (2) gleichgerichtet fließt.

6. Vorrichtung zum Abscheiden insbesondere kristalliner Schichten auf insbesondere kristallinen Substraten mit einer im Reaktorgehäuse (1) angeordneten Prozesskammer (2), deren Boden (3) mindesten einen in einer Lagerausnehmung (4) auf einen Gaspolster getragenen, durch den das Gaspolster aufrechterhaltenen, durch eine dem Boden zugeordneten Zuleitung (5) strömenden Gasstrom drehangetriebenen Substrathalter (6) trägt, **dadurch gekennzeichnet, dass** der Boden (3) von einem Höhlungsabschnitt eines ein im Wesentlichen rechteckiges Innenquerschnittsprofil aufweisenden, insbesondere mehrteiligen Grafitrohres (20, 22, 23) gebildet ist, wobei dem ersten Rohrende (10) ein Gaseinlassorgan (9) für ein oder mehrere Reaktionsgase zugeordnet ist und das zweite Rohrende (11) eine Beladeöffnung für die Prozesskammer (2) ausbildet und wobei vom Gaseinlassorgan (9) ein Reaktionsgas-Einlassrohr (12) bis zur stirnseitigen Öffnung der Prozesskammer (2) und ein davon getrenntes Rohr (13) bis zur darunter liegenden Öffnung der Zuleitung ausgehen, und, dass die Lagerausnehmung (4) einem über der Austrittsöffnung (7) der Zuleitung (5) angeordneten Tablett (8) zugeordnet ist.

7. Vorrichtung nach einem der vorhergehenden Ansprüche, **dadurch gekennzeichnet, dass** das die Prozesskammer (2) bildende Grafitrohr (20, 22, 23) von einer Graiftschaum-Manschette (21) umgeben ist.

8. Vorrichtung nach einem der vorhergehenden Ansprüche, **gekennzeichnet durch** vor der Stirnseite des Grafitrohres (20, 22, 23) und der Grafitschaum-Manschette (21) angeordnete Grafitscheiben (24, 25).

9. Verfahren zum Abscheiden insbesondere von Siliciumkarbit mittels in die Gasphase gebrachten metallorganischen Verbindungen in einer in einem Reaktorgehäuse (1) angeordneten Prozesskammer (2), deren Boden (3) mindestens einen in einer Lagerausnehmung (4) auf einem Gaspolster getragenen, durch den das Gaspolster aufrechterhalten, durch eine dem Boden zugeordneten Zuleitung (5) strömenden Gasstrom drehangetrieben Substrathalter (6) trägt, wobei die Lagerausnehmung (4) einem über der Austrittsöffnung (7) der Zuleitung (5) angeordneten Tablett (8) zugeordnet ist, welches zum Be- und Entladen der Prozesskammer entnommen wird.

## Claims

1. Device for depositing in particular crystalline layers on in particular crystalline substrates, having a process chamber (2) which is disposed in a reactor housing (1) and the base (3) of which carries at least one substrate holder (6), which is carried on a gas cushion in a bearing recess (4) and is driven in rotation by the gas stream which maintains the gas cushion and flows through a feed line (5) associated with the base, **characterized in that** the bearing recess (4) is associated with a tray (8) disposed above the outlet opening (7) of the feed line (5).

2. Device according to Claim 1, **characterized in that** the tray bears, by means of a sealing bead (14), against a step (15) of a graphite body (16) which forms the base (3).

3. Device according to Claim 2, **characterized in that** the annular sealing bead (14) is located in an annular groove (17) associated with the step (15).

4. Device according to Claim 3, **characterized by** passage openings (18) which, offset with respect to the outlet opening (7) surrounded by the annular groove (17), are surrounded by the sealing bead (14), for the bearing-gas stream to pass into the bearing recess (4).

5. Device according to one of the preceding claims, **characterized in that** the bearing-gas stream in the feed line (5) flows in the same direction as the flow of the reaction gases in the process chamber (2).

6. Device for depositing in particular crystalline layers on in particular crystalline substrates, having a process chamber (2) which is disposed in the reactor housing (1) and the base (3) of which carries at least one substrate holder (6), which is carried on a gas cushion in a bearing recess (4) and is driven in rotation by the gas stream which maintains the gas cushion and flows through a feed line (5) associated with the base, **characterized in that** the base (3) is formed by a cavity section of an in particular multipart graphite tube (20, 22, 23) which has a substantially rectangular internal cross-sectional profile, a gas inlet element (9) for one or more reaction gases being associated with the first tube end (10), and the second tube end (11) forming a loading opening for the process chamber (2), and a reaction-gas inlet tube (12) leading from the gas inlet member (9) to the end-side opening of the process chamber (2), and a separate tube (13) leading from the gas inlet member (9) to the feed line opening below it, and **in that** the bearing recess (4) is associated with a tray (8) which is disposed above the outlet opening of the feed line (7).

7. Device according to one of the preceding claims, **characterized in that** the graphite tube (20, 22, 23) which forms the process chamber (2) is surrounded by a graphite foam sleeve (21).

8. Device according to one of the preceding claims, **characterized by** graphite disks (24, 25) disposed in front of the end side of the graphite tube (20, 22, 23) and of the graphite foam sleeve (21).

9. Method for depositing in particular silicon carbide by means of metal-organic compounds which have been converted to the vapor phase in a process chamber (2) which is disposed in a reactor housing (1) and the base (3) of which carries at least one substrate holder which is carried on a gas cushion in a bearing recess (4) and is driven in rotation by the gas stream which maintains the gas cushion and flows through a feed line (5) associated with the base, the bearing recess (4) being associated with a tray (8) which is disposed above the outlet opening (7) of the feed line (5) and is removed in order for the process chamber to be loaded and unloaded.

## Revendications

1. Dispositif de dépôt de couches, en particulier cristallines, sur des substrats, en particulier cristallins, avec une chambre de traitement (2) placée dans un boîtier de réacteur (1) et dont le fond (3) supporte au moins un porte-substrat (6), supporté par un coussin de gaz dans un évidement de support (4) et entraîné en rotation par le flux de gaz s'écoulant à travers une conduite d'amenée (5) associée au fond et maintenant le coussin de gaz, dispositif **caractérisé en ce que** l'évidement de support (4) est associé à une tablette (8) placée au-dessus de l'ouverture de sortie (7) de la conduite d'amenée (5).

2. Dispositif selon la revendication 1, **caractérisé en ce que** la tablette repose au niveau d'un renflement d'étanchéité (14) sur un étage (15) d'un corps de graphite (16) formant le fond (3).

3. Dispositif selon la revendication 2, **caractérisé en ce que** le renflement d'étanchéité (14), de forme annulaire, se trouve dans une gorge annulaire (17) associée à l'étage (15).

4. Dispositif selon la revendication 3, **caractérisé par** des ouvertures de passage (18), qui sont décalées par rapport à l'ouverture de sortie (7) entourée par la gorge annulaire (17) et entourées par le renflement d'étanchéité (14) et qui sont destinées au passage du flux de gaz de support dans l'évidement de support (4).

5. Dispositif selon l'une des revendications précédentes, **caractérisé en ce que** le flux de gaz de support dans la conduite d'amenée (5) s'écoule dans le même sens que l'écoulement des gaz de réaction dans la chambre de traitement (2).

6. Dispositif de dépôt de couches, en particulier cristallines, sur des substrats, en particulier cristallins, avec une chambre de traitement (2) placée dans un boîtier de réacteur (1) et dont le fond (3) supporte au moins un porte-substrat (6), supporté par un coussin de gaz dans un évidement de support (4) et entraîné en rotation par le flux de gaz s'écoulant à travers une conduite d'amenée (5) associée au fond et maintenant le coussin de gaz, dispositif **caractérisé en ce que** le fond (3) est formé par une portion de cavité d'un tube de graphite (20, 22, 23), qui est en particulier constitué de plusieurs parties et qui présente un profil intérieur en coupe transversale sensiblement rectangulaire, un organe (9) d'introduction d'un ou plusieurs gaz de réaction étant associé à la première extrémité (10) du tube et la deuxième extrémité (11) du tube formant une ouverture de chargement de la chambre de traitement, et un tube d'introduction de gaz de réaction (12) partant de l'organe d'introduction de gaz (9) et allant jusqu'à l'ouverture du côté frontal de la chambre de traitement (2) et un tube (13), séparé du précédent, allant jusqu'à l'ouverture sous-jacente de la conduite d'amenée, et **en ce que** l'évidement de support (4) est associé à une tablette (8) placée au-dessus de l'ouverture de sortie (7) de la conduite d'amenée (5).

7. Dispositif selon l'une des revendications précédentes, **caractérisé en ce que** le tube de graphite (20, 22, 23) formant la chambre de traitement (2) est entouré par un manchon (21) en mousse de graphite.

8. Dispositif selon l'une des revendications précédentes, **caractérisé par** des disques (24, 25) placés devant le côté frontal du tube de graphite (20, 22, 23) et du manchon (21) en mousse de graphite.

9. Procédé de dépôt, en particulier de carbure de silicium, au moyen de composés métallo-organiques amenés en phase gazeuse dans une chambre de traitement (2), placée dans un boîtier de réacteur (1) et dont le fond (3) supporte au moins un porte-substrat (6), supporté par un coussin de gaz dans un évidement de support (4) et entraîné en rotation par le flux de gaz s'écoulant à travers une conduite d'amenée (5) associée au fond et maintenant le coussin de gaz, l'évidement de support étant associé à une tablette (8), placée au-dessus de l'ouverture de sortie (7) de la conduite d'amenée (5) et retirée pour charger et décharger la chambre de traitement.
